# EUROPEAN PATENT APPLICATION

(11) **EP 4 574 424 A1**
(43) Date of publication of application: **25.06.2025**
(21) Application number: 23219993.5
(22) Date of filing: 22.12.2023
(51) Int. Cl.: B32B 27/08, B32B 27/20, B32B 27/32, C09J 7/24, C09J 7/38, C09J 11/04, C09J 11/06, H01L 21/683

(54) **DICING TAPE AND RELATED METHODS**

(71) Applicant: Nitto Advanced Film Gronau, 48599 Gronau (DE); NITTO DENKO CORPORATION, Ibaraki-shi Osaka 567-8680 (JP)
(72) Inventor: Boccuto, Domenico, 48599 Gronau (DE)
(74) Representative: Grünecker Patent- und Rechtsanwälte PartG mbB

(57) **Abstract**

Described is a dicing tape comprising: a base layer, a first outer layer which is provided over the base layer and differs from the base layer, and an optional pressure-sensitive adhesive layer; wherein the base layer and the first outer layer comprise a polyolefin-based copolymer; and wherein the first outer layer comprises an organic or inorganic filler in an amount of 3 to 25 wt.-% based on the total weight of the respective layer. The dicing tape avoids the use of PVC-based substrate layers, exhibits excellent cutting properties during the dicing process (without whiskers, linting or chipping) and simultaneously ensures favourable mechanical performance. In other aspects, a dicing method, comprising the steps of: mounting a semiconductor wafer onto the aforementioned dicing tape, dicing the semiconductor wafer, and separating the wafer from the dicing tape is disclosed. Finally, a method of manufacturing the aforementioned dicing tape is described, wherein the dicing tape is produced by a multilayer blown film extrusion process.

## Description

### FIELD OF INVENTION

The present invention relates to a dicing tape used for manufacturing semiconductor chips. In detail, the present invention relates to a dicing tape to be bonded to a semiconductor wafer, and to be used in dicing and in die bonding.

In certain embodiments, this invention relates to a method for manufacturing a semiconductor chip or device using the dicing tape.

### BACKGROUND OF THE INVENTION

Dicing tapes (also known as dicing films, dicing die-bonding films or tapes, and die-attach films and tapes) are widely used in the process of manufacturing semiconductor chips and devices. For this purpose, a semiconductor wafer is typically pasted and affixed to the dicing tape, and dicing is performed in this state to process the wafer into individual pieces having a prescribed size which later serve as semiconductor chips. Thereafter, the individual semiconductor chips are picked up, thus peeling the semiconductor chips from the dicing film.

Prior to pickup, the wafers may be separated by expanding the underlying dicing film in order to enlarge a gap between the cut semiconductor members. During the expansion, the dicing film must exhibit sufficient toughness to avoid breakage.

Conventionally, dicing films used in such semiconductor manufacturing processes are generally comprised of a substrate layer and a pressure-sensitive adhesive layer and are required to have good cutting properties and good mechanical relaxation properties.

For this purpose, dicing films using polyvinyl chloride (PVC)-based substrate layers have been widely employed, since they exhibit excellent mechanical performance (e.g., tensile properties) and thermal stability.

However, there are growing demands to avoid the use of PVC in dicing films, both in view of environmental issues and due to potential contamination of semiconductor members with chloride and corrosion.

Therefore, in recent years, dicing films using non-PVC resin-based materials such as polyolefin resins or ethylenemethacrylic acid-acrylate-based resins have been developed (see, for example, JP H05211234 A and KR 101659057 B1). US 8 728 910 B2 discloses a dicing film that exhibits less contamination characteristics and high expandability, wherein the dicing film comprises an olefinic expandable substrate comprising a 1-butene-α-olefin copolymer and a propylenic elastomer composition comprising a propylene-α-olefin copolymer.

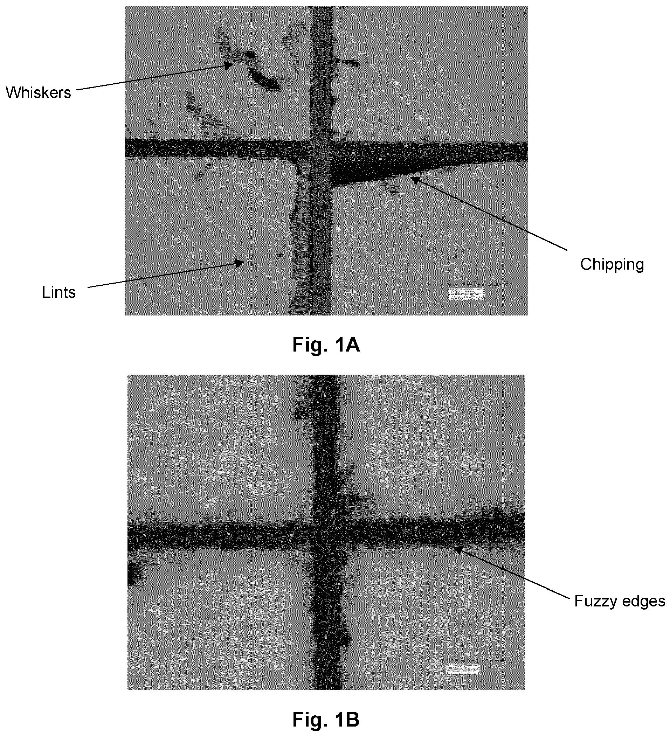

However, while adhesion levels on the semiconductor wafers may be suitably adjusted, dicing films comprising polyolefin-based substrate layers are prone to linting, formation of whiskers (fibrous off-cuts), chip fly and chipping during dicing (see Fig. 1A), and fuzzy cutting edges (see Fig. 1 B), overall resulting in poor quality cuts and reduced production yield.

Moreover, if whiskers adhere to the side of the chip, the reliability of the resultant semiconductor element may be severely reduced. In addition, if in the pickup step individual chips are picked up after positioning under recognition with a CCD camera, lints and whiskers may lead to recognition errors.

Therefore it remains desirable to provide dicing tapes and films which avoid the use of PVC-based substrate layers, exhibit excellent cutting properties during the dicing process (without whiskers, linting or chipping) and simultaneously ensure favourable mechanical performance during expansion.

Furthermore, it is desirable to provide a dicing tape and a dicing method which do not require different settings in the dicing process or new machinery when compared to the use of PVC-based dicing tapes.

### SUMMARY OF THE INVENTION

The present invention solves this object with the subject matter of the claims as defined herein. The advantages of the present invention will be further explained in detail in the section below and further advantages will become apparent to the skilled artisan upon consideration of the invention disclosure.

Generally speaking, in one aspect the present invention provides a dicing tape comprising: a base layer, a first outer layer which is provided over the base layer and differs from the base layer, and an optional pressure-sensitive adhesive layer; wherein the base layer and the first outer layer comprise a polyolefin-based copolymer; and wherein the first outer layer comprises an organic or inorganic filler in an amount of 3 to 25 wt.-% based on the total weight of the respective layer.

In other aspects, the present invention relates to a dicing method, comprising the steps of: mounting a semiconductor wafer onto the aforementioned dicing tape, dicing the semiconductor wafer, and separating the wafer from the dicing tape.

In further aspects, the present invention relates to a method of manufacturing the aforementioned dicing tape, wherein the dicing tape is produced by a multilayer blown film extrusion process.

### BRIEF DESCRIPTION OF THE DRAWINGS

FIG. 1A is an exemplary microscopic image of cutting defects (whiskers, linting, and chipping).
FIG. 1B is an exemplary microscopic image of cutting defects (fuzzy cutting lines).
FIG. 2A illustrates an exemplary dicing tape configuration according to the present invention including a double layer substrate.
FIG. 2B illustrates an exemplary dicing tape configuration according to the present invention with a triple layer substrate.
Fig. 3 illustrates an exemplary dicing method.
Fig. 4 shows force-strain curves measured for the Reference Example and the exemplary dicing tapes of the present invention (machine direction).
Fig. 5 depicts force-strain curves measured for the Reference Example and the exemplary dicing tapes of the present invention (transversal direction).

### DETAILED DESCRIPTION OF THE INVENTION

For a more complete understanding of the present invention, reference is now made to the following description of the illustrative embodiments thereof:

### Dicing Tape

In a first embodiment, the present invention generally relates to a dicing tape comprising: a base layer, a first outer layer which is provided over the base layer and differs from the base layer, and an optional pressure-sensitive adhesive layer; wherein the base layer and the first outer layer comprise a polyolefin-based copolymer; and wherein the first outer layer comprises an organic or inorganic filler in an amount of 3 to 25 wt.-% based on the total weight of the respective layer.

Notably, the dicing tape according to the present invention exhibits a substrate layer having a multilayer configuration with at least two sub-layers (i.e the first outer layer and the base layer), onto which a pressure-sensitive adhesive layer is typically provided. The terms "substrate" or "substrate layer", as used henceforth, define the layers of the dicing tape excluding pressure-sensitive adhesive (PSA) layers and release liners provided on the PSA layers.

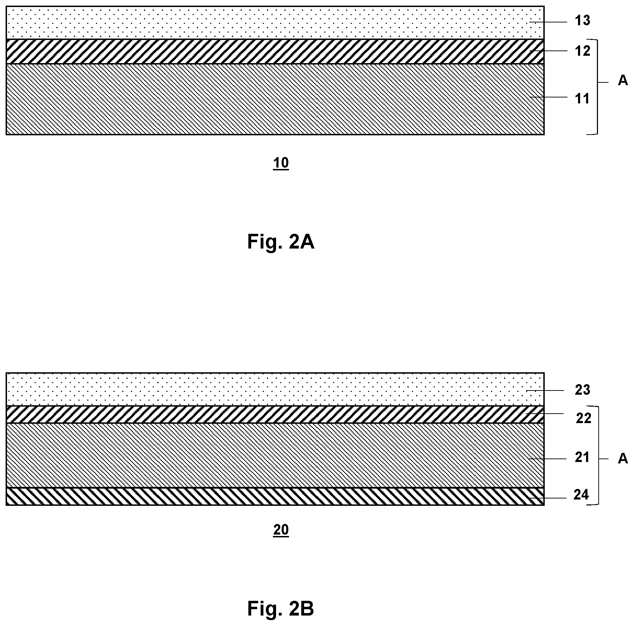

One non-limiting example of a dicing tape (10) of the present invention is shown in Fig. 2A. Herein, a first outer layer (12) is applied onto a base layer (11), and a pressure-sensitive adhesive layer (13) is provided over the first outer layer (12) to form the dicing tape (10).

However, additional layers may be provided within the dicing tape.

In a particularly preferred embodiment shown in Fig. 2B, the film substrate (A) comprises and especially preferably consists of three layers, i.e. the first outer layer (22), the base layer (21), and a second outer layer (24), which differs from the base layer (21) and which is provided on the side of the base layer (21) opposed to the first outer layer (22) and comprises a polyolefin-based copolymer. A pressure sensitive adhesive layer (23) may be provided over the first outer layer (22).

Generally, it is preferred that the dicing tape does not comprise a polyvinyl chloride (PVC) resin or another chlorine-containing resin.

Notably, the polyolefin-based copolymer used in the first outer layer, the base layer and the second outer layer (if present) may be identical or different. For simpler manufacturing and in order to ensure a good compatibility between the layers, it is preferable to use the same polyolefin-based copolymer in the first outer layer, the base layer and the second outer layer (if present). Examples of polyolefin-based copolymers which may be independently selected for use in the first outer layer, the base layer and the second outer layer (if present) will be described in the following.

In preferred embodiments, the polyolefin-based copolymer is independently selected from polypropylene copolymers, especially polypropylene random copolymers formed from propylene, ethylene and/or ethylene-α-olefins. Further preferably, the polyolefin-based copolymer is independently selected from ethylene-propylene copolymers, and particularly preferably from multistep-polymerized ethylene-polypropylene copolymers.

Among polyolefin-based copolymers, heterophasic reactor thermoplastic polyolefin (rTPO) are particularly preferred from the viewpoint of tensile properties, thermal stability. Such rTPOs, also known as "in-reactor thermoplastic polyolefin resins", are produced in a multistep process in a reactor and exhibit a characteristic morphology different than that obtained by blending multiple polyolefins. Especially preferred examples of rTPOs in terms of physical requirements during the dicing process include a highly isotactic polypropylene matrix with a rubber component comprising ethylene/propylene copolymers dispersed in the matrix.

The polyolefin-based copolymer preferably exhibits a melting temperature determined according to ISO 11357-3 of higher than 120°C, preferably higher than 125°C, more preferably higher than 130°C and especially preferably higher than 135 °C.

In a preferred embodiment, the polyolefin-based copolymer preferably exhibits a flexural modulus determined according to ISO 178 of 50 MPa to 500 MPa, more preferably 60 MPa to 300 MPa, further preferably 70 to 200 MPa, and especially preferably from 75 to 150 MPa.

Unless noted otherwise, all test methods related to the physical and tensile test properties mentioned herein are conducted at room temperature, i.e. at about 23°C.

In another preferred embodiment, the polyolefin-based copolymer has an ethylene content of higher than 13 wt.-% based on the total weight of the polyolefin-based copolymer, preferably an ethylene content of higher than 14.5 wt.-%, more preferably an ethylene content of higher than 15 wt.-% and less than 40 wt.-%, and especially preferably an ethylene content of higher than 17 wt.-% and less than 35 wt.-%. The ethylene content may be suitably determined according to methods known in the art, such as by FT-IR spectroscopy after calibration via quantitative ¹³C-NMR spectroscopy.

While not being limited thereto, it may be preferred that the polyolefin-based copolymer has a melt flow rate (230°C/2.16 kg) determined according to ISO 11357-3 of 1.8 g/10 min or less, preferably 1.6 g/10 min or less.

The first outer layer and the second outer layer (if present) independently preferably comprise the polyolefin-based copolymer selected from the above-described copolymers in an amount of 55 to 85 wt.-% based on the total weight of the respective layer, further preferably in an amount of 60 to 80 wt.-%, especially preferably in an amount of 65 to 75 wt.-%. On the other hand, the base layer preferably comprises the polyolefin-based copolymer selected from the above-described copolymers in an amount of 80 to 100 wt.-% based on the total weight of the base layer, further preferably in an amount of 85 to 98 wt.-% based on the total weight of the base layer.

From the viewpoint of a favourable dicing tape cuttability and cut quality, the first outer layer and the second outer layer (if present) independently comprise an organic or inorganic filler in an amount of 3 to 25 wt.-% based on the total weight of the respective layer, preferably in an amount of 5 to 22 wt.-%, and especially preferably in an amount of 10 to 20 wt.-% based on the total weight of the respective layer. In embodiments, filler amounts in the range of 15 to 20 wt.-% may be preferred.

In view of the above, it is preferred that the weight ratio of the polyolefin-based copolymer to the filler in the outer layer(s) is lower than the weight ratio of the polyolefin-based copolymer to the filler in the base layer. Due to the relatively higher amount of filler and due to the lower proportion of polyolefin-based copolymer in the outer layer(s), the tendency of blocking (i.e. the film layers sticking to themselves when being wound onto a roll) may be reduced. This effect is also achieved when using relatively thin outer layers.

The type of filler may be any of an inorganic filler and an organic filler. Examples of organic fillers include, but are not limited to, cellulose-based fillers (such as cellulose nanofibers or cellulose crystals, for example). Examples of inorganic fillers include various inorganic powders composed of talc, silica, clay, gypsum, calcium carbonate, barium sulfate, alumina oxide, beryllium oxide, ceramics such as silicone carbide and silicone nitride, and metals or alloys (such as aluminum, copper, silver, gold, nickel, chromium, lead, tin, zinc, palladium, and solder, carbon, and the like) to impart conductivity to the dicing film, if desired. The filler may be employed singly or in a combination of two or more kinds. For improved control of elastic modulus of the dicing tape and in view of reduced manufacturing costs, talc is especially preferred as filler material.

In preferred embodiments from the viewpoint of dicing cut quality, the organic or inorganic filler has an average particle size (d50) determined by a laser diffraction method in the range of 1 to 10 µm, more preferably in the range of 2 to 5 µm.

Preferably, the first outer layer, the base layer and the second outer layer (if present) independently comprise a low-density polyethylene (LDPE) and/or a linear low density polyethylene (LLDPE). While the amount thereof is not particularly limited, a (total) content of 2 to 25 wt.-% based on the total weight of the respective layer and a content of 5 to 20 wt.-% is particularly preferred.

For particularly improved physical properties of the dicing tape, the low-density polyethylene (LDPE) and/or linear low density polyethylene (LLDPE) exhibit a modulus of elasticity in transverse direction (TD) in the range of from 160 MPa to 600 MPa, preferably 180 MPa to 400 MPa, and a modulus of elasticity in machine direction (MD) in the range of from 140 MPa to 550 MPa, preferably 170 to 380 MPa, the moduli of elasticity being determined according to ISO 527-3 at 23°C.

In addition to or in alternative to LLDPE and/or LDPE, the first outer layer, the base layer and the second outer layer (if present) may independently comprise any of a very low-density polyethylene (VLDPE), an ultra low-density polyethylene (ULDPE), or an ethylene-alpha-olefin plastomer with a tensile modulus (according to ISO 527-3) of 50 to 200 MPa and a density of less than 0.915 g/cm³ and preferably 0.885 - 0.915 g/cm³ to fine-tune the mechanical properties of the dicing film. Among these polymers, those polymerized via metallocene catalysis are preferred.

The first outer layer, the base layer and the second outer layer (if present) may independently contain further additives. For long-term durability, additives selected from one or more of phenolic stabilizers (e.g., Irganox 1010), processing aids (e.g., antiblock agents) and antistatic-additives may be added. Other additives can be suitably blended according to the necessity, such as one or more selected from colorants, flame retardants, extenders, antioxidants and surfactants.

The first outer layer, the base layer and the second outer layer (if present) may independently comprise slip agents, preferably in an amount of 0.001 wt % to 1.0 wt %, based upon the weight of the respective layer. Slip agents include but are not limited to unsaturated fatty acid amides (e.g., erucamide, oleamide, and linoleamide); saturated fatty acid amides (e.g., palmitamide, stearamide, arachidamide, behenamide, stearyl stearamide, palmityl pamitamide, and stearyl arachidamide); saturated ethylene-bis-amides (e.g., stearamido-ethyl-stearamide, stearamido-ethyl-palmitamide, and palmitamido-ethyl-stearamide); unsaturated ethylene-bis-amides (e.g., ethylene-bis-stearamide, ethylene-bis-oleamide, stearyl-erucamide, erucamido-ethyl-erucamide, oleamido-ethyl-oleamide, erucamido-ethyl-oleamide, oleamido-ethyl-lerucamide, stearamido-ethyl-erucamide, erucamido-ethyl-palmitamide, and palmitamido-ethyl-oleamide); polyether polyols; glycols; acids of aliphatic hydrocarbons (e. g., adipic acid and sebacic acid); esters of aromatic or aliphatic hydrocarbons (e.g., pentaerythritol monooleate); styrene-alpha-methyl styrene; fluoro-containing polymers (e.g., polytetrafluoroethylene); silicon compounds (e.g., silicone oils); sodium alkylsulfates, alkyl phosphoric acid esters; stearates (such as zinc stearate); and mixtures thereof.

In a triple layer substrate configuration, it is preferred that the first outer layer and the second outer layer have the same composition. Such an embodiment not only simplifies the manufacturing process, but also provides advantages in terms of expansion and shrinkage behavior due to the symmetrical profile.

The substrate layer in its entirety preferably has a tensile modulus of from 30 to 80 N/mm² in machine direction (MD), more preferably from 40 to 60 N/mm², and/or a tensile modulus of from 20 to 60 N/mm² in transversal direction (TD), more preferably from 30 to 50 N/mm². In addition or alternatively, the substrate layer preferably has an elongation at break (MD) in the range of from 150 to 850%, more preferably from 200 to 700%, and/or an elongation at break (TD) in the range of from 200 to 900%, more preferably from 250 to 850%. Furthermore, the substrate layer may have a tensile strength (MD) in the range of from 15 to 45 N/mm², more preferably from 20 to 40 N/mm², and/or a tensile strength (TD) in the range of from 5 to 30 N/mm², more preferably from 10 to 25 N/mm². The tensile modulus, elongation at break and tensile strength may be determined in accordance to ISO 527 (1-3).

In another preferred embodiment, the substrate layer exhibits a dimensional stability both in MD and TD of less than 10%, more preferably less than 5% and especially preferably less than 2%. The dimensional stability may be measured upon heating at 80°C for 1 h according to DIN 53377.

Preferably, the substrate layer has a tear resistance determined according to ISO 6383-2 both in MD and TD of more than 500 N/cm, more preferably at least 700 N/cm, and especially preferably at least 1000 N/cm.

A pressure-sensitive adhesive layer may be provided in contact with the first outer layer and/or the second outer layer (if present) for adhesion to the wafer. Also, a pressure-sensitive adhesive layer may be provided on each side of the substrate.

The surface of the substrate on which the pressure-sensitive adhesive layer is provided may be subjected to a physical or chemical treatment to facilitate and/or improve bonding between the substrate and the adhesive layer, such as a plasma or corona discharge treatment.

The pressure-sensitive adhesive layer is not particularly limited and its composition may be suitably selected by the skilled artisan from materials known in the art. Examples of the adhesive composition include rubber adhesives, acrylic adhesives, silicone adhesives, and thermoplastic elastomers such as styrenic elastomers and olefinic elastomers. The pressure-sensitive adhesive layer may be composed of radiation-curable adhesives of which the adhesive force decreases by radiation rays or heat-curable adhesives of which the adhesive force decreases by heat. Examples of the radiation-curable adhesives preferably include UV-curable adhesives.

The pressure-sensitive adhesive layer preferably has a thickness of 1 to 100 µm, further preferably from 2 to 50 µm and especially preferably from 3 to 20 µm, in order to suppress an excessive increase in the amplitude of the vibration typically occurring during dicing of the semiconductor wafer, thus reducing dicing defects or chipping of the wafer.

Prior to use in the dicing process, each adhesive face of the dicing tape may optionally be protected by a release liner or may be protected in a roll form wound with one release liner having a release face on each side. The release liner may be used as a protective material of the pressure-sensitive adhesive layer and may be peeled off in lamination of the sheet onto the workpiece. The release liner is not particularly limited and may comprise a release layer (release-treated layer) on at least one surface of the release liner substrate, a low-adhesive release liner comprising a fluorine polymer, and a low-adhesive release liner comprising a nonpolar polymer, for example.

The total thickness of the dicing tape (excluding the optional release liner) is preferably in a range of from 50 to 300 µm and further preferably in a range of 80 to 200 µm.

The thickness of the base layer preferably constitutes more than 50% of the total thickness of the base layer, the first outer layer and the second outer layer (if present). In preferred embodiments, the base layer generally has a thickness in the range of from 30 to 150 µm. Whereas in a two layer substrate configuration, the base layer preferably has a thickness of from 45 to 150 µm, in a three layer substrate configuration, the base layer preferably has a thickness of from 30 to 120 µm.

The thickness of the first outer layer is typically in the range of from 2 to 80 µm, more preferably from 5 to 50 µm. Whereas in a two layer substrate configuration, the first outer layer preferably has a thickness of from 5 to 40 µm, in a three layer substrate configuration, the base layer preferably has a thickness of from 10 to 50 µm, especially preferably from 10 to 25 µm.

The thickness of the second outer layer is typically in the range of from 2 to 80 µm, more preferably from 5 to 50 µm, further preferably from 7 to 50 µm, and especially preferably from 10 to 25 µm. If the first and the second outer layers have the same composition, it is preferred that the difference of their thicknesses is less than 10 µm, more preferably less than 5 µm, especially preferably less than 2 µm, such as 1 µm or less.

In view of the constitution of the substrate layers, the aforementioned thickness ranges provide a particularly favourable balance between tensile properties, stiffness and tear strength of the dicing tape and thus enable dicing with improved cut quality.

In addition, if the weight ratio of the polyolefin-based copolymer to the filler in the outer layer(s) is lower than the weight ratio of the polyolefin-based copolymer to the filler in the base layer, the elongation modulus of the outer layer(s) will be typically higher than that of the base layer, thin outer layers (e.g., with a thickness of from 5 to 40 µm (two-layer configuration) or 10 to 25 µm (three-layer configuration)) have the advantage that the tapes can be stretched with lower forces while maintaining good die-cuttability.

### Dicing Method

In a second embodiment, the present invention relates to a dicing method, comprising the steps of: mounting a semiconductor wafer onto the dicing tape according to the fist embodiment, dicing the semiconductor wafer, optionally expanding the dicing tape and separating the diced semiconductor wafer from the dicing tape.

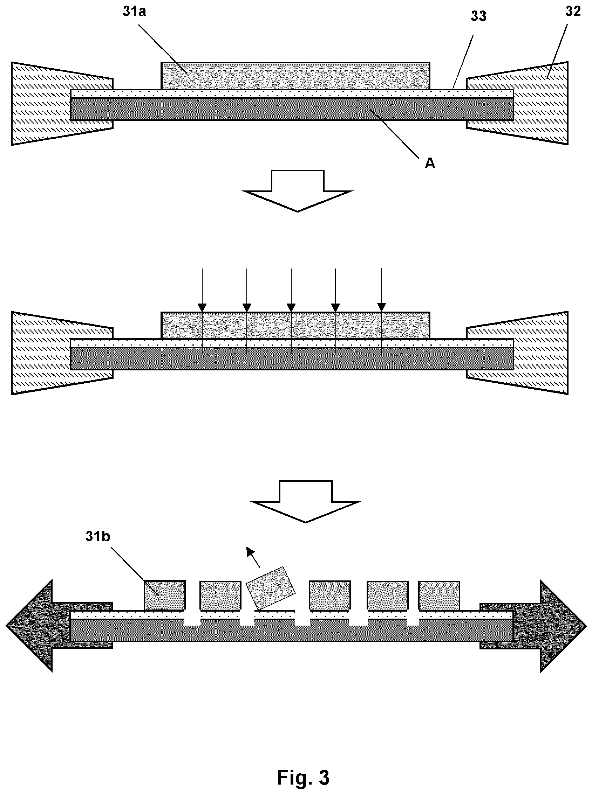

An exemplary dicing method is illustrated in Fig. 3.

A semiconductor wafer (31a) (which is not particularly limited and may be made of silicon, gallium or arsenic, for example), which is generally produced in a state having a large diameter, is first mounted onto the dicing tape described in conjunction with the first embodiment above, preferably by adhering the same to the pressure-sensitive adhesive layer (33) of the dicing tape. The dicing tape may be fixed in a holding frame (32).

Thereafter, the semiconductor wafer (31a) is subjected, while sticking to the dicing tape, to dicing.

In the dicing step, a method in which the semiconductor wafer (31a) is cut with a dicing blade may be employed. Blade cutting methods are prone to producing minute defects (also referred to as "chipping") on the semiconductor chip (32b). It is preferred to adjust the cutting depth so that the blade only touches or cuts partially through the outer layer in proximity of the wafer while leaving the base layer intact, so that due to the stiffness of the outer layer, the occurrence of lints and whiskers may be minimized. Accordingly, the use of dicing tapes according to the present invention is particularly advantageous when using blade cutting methods.

Alternatively, a stealth dicing method may be used for cutting ultra thin semiconductor wafers (31a), e.g., by irradiating a laser beam onto the semiconductor wafer (31a) so that the focal point of the laser beam is located inside the interior of the semiconductor wafer, thereby forming a brittle modified section inside the semiconductor wafer (31a) as a result of multiphoton absorption.

Cutting is done in parallel and perpendicular lines to finally obtain the desired dices / squares out of the wafer.

Subsequently, the dicing tape affixed to the rear surface of the semiconductor wafer may be expanded. The expansion step may be generally conducted regardless of whether the dicing step is performed using the blade dicing method or the stealth dicing method. When the dicing step is performed using the stealth dicing method, then as described above, the expansion step additionally functions as a step for dividing the semiconductor wafer in which the dicing lines have been formed into individual semiconductor chips (31b).

Thereafter, the diced semiconductor wafer (31b) (i.e. chip) is separated from the dicing tape by picking the same up from the dicing tape. While not being limited thereto, a collet and a needle may be used to detach the chip from the dicing tape.

### Method of Manufacturing the Dicing Tape

The method of manufacturing the dicing tape according to the first embodiment described above is not particularly limited and several methods known in the art may be used.

The method of making the individual sub-layers of the substrate (i.e. the base layers and the first and second outer layers) can be carried out by a conventionally known film-making method, e.g. by calender film making, casting film making, inflation extrusion, T-die extrusion, or the like. The multilayer film can be then produced by a conventional film lamination method such as co-extrusion method or dry lamination method.

According to a third embodiment of the present invention, however, the dicing tape is produced by a multilayer blown film extrusion process. The thus obtained film structure has been shown to exhibit favourable isotropic properties compared to cast multilayer films and further reduces the shrink tendency of the resulting dicing tape, thus enabling more consistent quality and performance of the dicing tape.

A pressure-sensitive adhesive layer is typically provided on the multilayer substrate film. As already mentioned above, the surface of the substrate on which the pressure-sensitive adhesive layer is provided may be subjected to a physical or chemical treatment to facilitate and/or improve bonding between the substrate and the adhesive layer, such as a plasma or corona discharge treatment.

It will be appreciated that the present invention may employ any of the preferred features specified above with respect to the description of the first to third embodiments, and that the preferred features may be combined in any combination, except for combinations where at least some of the features are mutually exclusive.

### EXAMPLES

Exemplary dicing tapes with a triple layer substrate configuration were prepared, labelled as Example 1 and Example 2. For this purpose, compositions as shown in Table 1 were blended and subjected to multilayer blown film extrusion to form symmetrical multilayer substrates. Both samples were identical except from the thicknesses of the first outer layer, the base layer and the second outer layer:

**TABLE 1**

| | | First Outer Layer | Base Layer | Second Outer Layer |
|---|---|---|---|---|
| Example 1 | Composition | 70 wt.-% rTPO | 95 wt.-% rTPO | 70 wt.-% rTPO |
| | | 15 wt.-% PP | 5 wt.-% LLDPE | 15 wt.-% PP |
| | | 10 wt.-% filler | | 10 wt.-% filler |
| | | 5 wt.-% LLDPE | | 5 wt.-% LLDPE |
| | Thickness [µm] | 14 | 42 | 14 |
| Example 2 | Composition | 70 wt.-% rTPO | 95 wt.-% rTPO | 70 wt.-% rTPO |
| | | 15 wt.-% PP | 5 wt.-% LLDPE | 15 wt.-% PP |
| | | 10 wt.-% filler | | 10 wt.-% filler |
| | | 5 wt.-% LLDPE | | 5 wt.-% LLDPE |
| | Thickness [µm] | 16 | 48 | 16 |

Adflex Q 190 F, commercially available from LyondellBasell, was used as heterophasic reactor thermoplastic polyolefin (rTPO), having a density of 0.880 g/cm³ (ISO 1183), a melt flow rate of 0.6 g/10 min (230°C/2.16 kg; ISO 1133), a tensile stress at break of 10 MPa (ISO 527-1/2), a flexural modulus of 100 MPa (ISO 178) and a melting temperature of 142°C (ISO 11357-3). PP denotes a polypropylene homopolymer. As LLDPE, SABIC^{®} LLDPE 118 NE, a butene-linear low density polyethylene with a density of 0.918 g/cm³ and a melt flow rate of 1.0 g/ 10 min was used. As a filler, talc having an average particle size (d50) between 2 and 5 µm was used. An acrylic pressure-sensitive adhesive was applied on the multilayer substrates of both Example 1 and 2.

Examples 1 and 2 were tested for its mechanical properties and compared to the commercially available dicing tape Nitto V-8AR (Reference Example), which comprises a PVC-based substrate with a thickness of 80 µm. The results are shown in the following Table 2.

**TABLE 2**

| Characteristic | Example 1 | Example 2 | Reference Example |
|---|---|---|---|
| Tensile Modulus (MD) [N/mm²] ¹⁾ | 51.9 | 51.6 | 51.1 |
| Tensile Modulus (TD) [N/mm²] ¹⁾ | 41.4 | 43.6 | 42.6 |
| Elongation at Break (MD) [%] ¹⁾ | 583 | 590 | 242 |
| Elongation at Break (TD) [%] ¹⁾ | 759 | 794 | 321 |
| Tensile Strength (MD) [N/mm²] ¹⁾ | 29.9 | 30.8 | 27.7 |
| Tensile Strength (TD) [N/mm²] ¹⁾ | 16.2 | 19.4 | 14.7 |
| Dimensional Stability (MD) [%] ²⁾ | < 2 | < 2 | < 10 |
| Dimensional Stability (TD) [%] ²⁾ | < 2 | < 2 | < 10 |
| Tear Resistance (MD) [N/cm] ³⁾ | 1000 | 1000 | > 700 |
| Tear Resistance (TD) [N/cm] ³⁾ | 1000 | 1000 | > 700 |

| | | | |
|---|---|---|---|
| 1) ISO 527 (1-3); 2) measured at 80°C/1h according to DIN 53377; 3) ISO 6383-2 | | | |

The above results indicate a high similarity between the inventive dicing tape and a PVC-based dicing tapes, especially with respect to the tensile characteristics. The films according to Examples 1 and 2 demonstrate excellent dimensional stability and tear resistance.

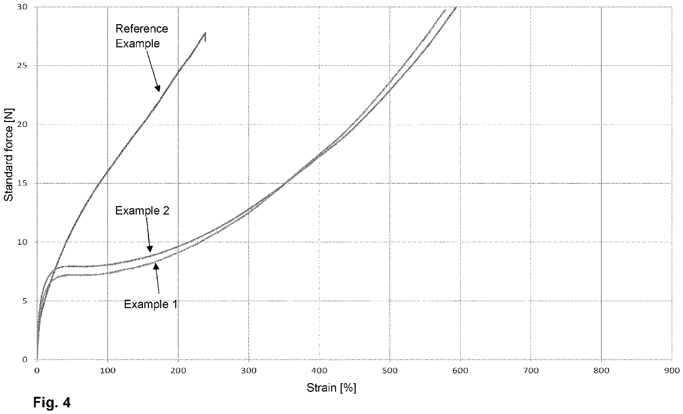

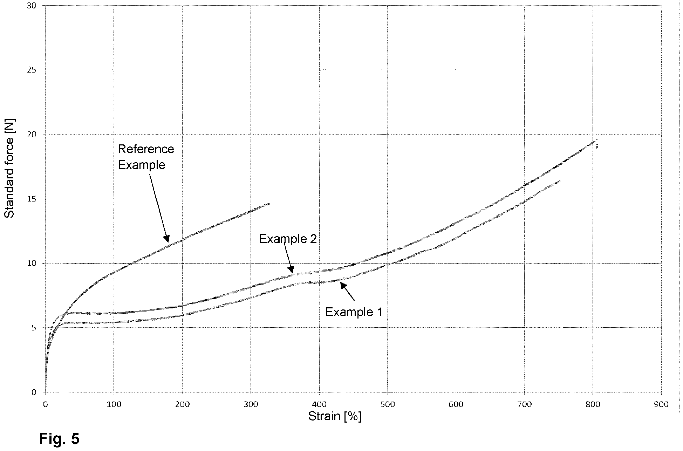

Force-strain characteristics measured for the films of Examples 1 and 2 as well as the Reference Example are shown in Fig. 4 (in machine direction (MD)). No definite yield point was detected for the films according to the invention. Fig. 5 shows the force-strain characteristics in transversal direction (TD) (or cross direction (CD), respectively).

For comparison, two polyethylene-based films (not including a filler) with a thickness of 80 µm were cut under identical conditions as Examples 1 and 2 and labelled as Comparative Examples 1 and 2.

The dicing tapes according to Examples 1 and 2 as well as that of the Reference Example were subjected to cutting in accordance with typical dicing conditions.

The diced chips were independently examined microscopically. The results of the evaluation are summarized in Table 3, wherein "+" denotes no or very minor defects, "o" denotes minor, but acceptable defects, and "-" denotes substantial and unacceptable defects.

**TABLE 3**

| Defect | Reference Example | Example 1 | Example 2 | Comparative Example 1 | Comparative Example 2 |
|---|---|---|---|---|---|
| chipping / chip fly | + | + | + | - | ○ |
| whiskers / lints | + | + | ○ | ○ | - |
| fuzzy cutting lines | + | + | ○ | - | - |

The above results demonstrate that the dicing films according to the present invention exhibit excellent cutting properties and mechanical relaxation characteristics comparable or better than those of conventional PVC-based dicing films.

Once given the above disclosure, many other features, modifications, and improvements will become apparent to the skilled artisan.

### REFERENCE NUMERALS

- 10/20: Dicing Tape
- A: Substrate
- 11/21: Base Layer
- 12 / 22: First Outer Layer
- 13 / 23 / 33: Pressure-Sensitive Adhesive Layer
- 24: Second Outer Layer
- 31a: Wafer
- 31b: Diced Wafer
- 32: Frame

## Claims

1. Dicing tape comprising:
a base layer,
a first outer layer which is provided over the base layer and differs from the base layer, and
an optional pressure-sensitive adhesive layer;
wherein the base layer and the first outer layer comprise a polyolefin-based copolymer;
wherein the first outer layer comprises an organic or inorganic filler in an amount of 3 to 25 wt.-% based on the total weight of the respective layer.

2. Dicing tape according to claim 1, further comprising a second outer layer which differs from the base layer, and which is provided on the side of the base layer opposed to the first outer layer and comprises a polyolefin-based copolymer.

3. Dicing tape according to claim 2, wherein the first outer layer and the second outer layer independently comprise an organic or inorganic filler in an amount of 3 to 25 wt.-% based on the total weight of each outer layer, preferably in an amount of 5 to 22 wt.-%, more preferably in an amount of 10 to 20 wt.-%.

4. Dicing tape according to any one of claims 1 to 3, wherein the polyolefin-based copolymer is a polypropylene copolymer, preferably an ethylene-propylene copolymer, more preferably a multistep-polymerized ethylene-polypropylene copolymer.

5. Dicing tape according to any one of claims 1 to 4, wherein the polyolefin-based copolymer is a heterophasic reactor thermoplastic polyolefin (rTPO).

6. Dicing tape according to any one of claims 1 to 5, wherein the polyolefin-based copolymer has an ethylene content of higher than 13 wt.-% based on the total weight of the polyolefin-based copolymer, preferably an ethylene content of higher than 14.5 wt.-%, and more preferably an ethylene content of higher than 17 wt.-% and less than 35 wt.-%.

7. Dicing tape according to any one of claims 1 to 6, wherein the polyolefin-based copolymer has a flexural modulus determined according to ISO 178 of 50 MPa to 500 MPa, preferably 60 MPa to 300 MPa, more preferably 70 to 200 MPa, especially preferably from 75 to 150 MPa, and/or wherein the polyolefin-based copolymer has a melting temperature determined according to ISO 11357-3 of higher than 120°C, preferably higher than 125°C, more preferably higher than 130°C and especially preferably higher than 135 °C.

8. Dicing tape according to any one of claims 1 to 7, wherein the first outer layer and the second outer layer, if present, independently comprise the polyolefin-based copolymer in an amount of 60 to 80 wt.-% based on the total weight of the respective layer, and/or wherein the base layer comprises the polyolefin-based copolymer in an amount of 85 to 100 wt.-% based on the total weight of the base layer.

9. Dicing tape according to any one of claims 1 to 8, wherein the organic or inorganic filler has an average particle size (d50) determined by a laser diffraction method in the range of 1 to 10 µm, preferably in the range of 2 to 5 µm.

10. Dicing tape according to any one of claims 1 to 9, wherein the filler is an inorganic filler selected from one or more of talc, clay, silica and calcium carbonate, preferably from talc and calcium carbonate, and more preferably talc.

11. Dicing tape according to any one of claims 1 to 10, wherein the first outer layer, the base layer and/or the optional second outer layer independently comprise 2 to 25 wt.-% and preferably 5 to 20 wt.-% of a low-density polyethylene (LDPE) or linear low density polyethylene (LLDPE), based on the total weight of the respective layer.

12. Dicing tape according to claim 11, wherein the low-density polyethylene (LDPE) or linear low density polyethylene (LLDPE) has a modulus of elasticity in transverse direction (TD) in the range of from 160 MPa to 600 MPa, preferably 180 MPa to 400 MPa, and a modulus of elasticity in machine direction (MD) in the range of from 140 MPa to 550 MPa, preferably 170 to 380 MPa, the moduli of elasticity being determined according to ISO 527-3 at 23°C.

13. Dicing tape according to any one of claims 1 to 12, satisfying one or more of the following features a) to e):
a) the thickness of the base layer constitutes more than 50% of the total thickness of the total thickness of the base layer, the first outer layer and the second outer layer, if present;
b) the base layer has a thickness in the range of from 30 to 150 µm;
c) the total thickness of the dicing tape is in a range of from 50 to 300 µm, preferably in a range of 80 to 200 µm;
d) the thickness of the first outer layer is in the range of from 2 to 80 µm, preferably from 5 to 50 µm; and
e) the thickness of the optional second outer layer is in the range of from 2 to 80 µm, preferably from 5 to 50 µm.

14. Dicing method, comprising the steps of:
mounting a semiconductor wafer onto the dicing tape according to any one of claims 1 to 13,
dicing the semiconductor wafer,
optionally expanding the dicing tape, and
separating the diced semiconductor wafer from the dicing tape.

15. Method of manufacturing a dicing tape according to any one of claims 1 to 13, wherein the dicing tape is produced by a multilayer blown film extrusion process.
